# EUROPEAN PATENT SPECIFICATION

(11) **EP 0 415 541 B1**
(45) Date of publication and mention of the grant of the patent: **05.10.1994**
(21) Application number: 90307957.2
(22) Date of filing: 20.07.1990
(51) Int. Cl.: H01L 31/115, G01T 1/24, H01L 21/60, H01L 31/18

(54) **Semiconductor-based radiation image detector and its manufacturing method**
Halbleiterstrahlungsbilddetektor und sein Herstellungsverfahren
Détecteur d'image radiative à base de semi-conducteur et sa méthode de fabrication

(30) Priority: 29.07.1989 JP 197884/89
(43) Date of publication of application: 06.03.1991
(73) Proprietor: SHIMADZU CORPORATION, Kyoto 604 (JP)
(72) Inventor: Sato, Kenji, Otsu-shi (JP)
(74) Representative: Smith, Philip Antony

(56) References cited:
- US-A- 4 661 192
- US-A- 4 670 653
- IEEE TRANSACTIONS ON PARTS, HYBRIDS AND PACKAGING. vol. 11, no. 4, December 1975, New York, US, pp. 312-315; D.A.GORSKI et al.: "FLIP-CHIP HEADER FOR IR DETECTOR ARRAYS OPERATING AT CRYOGENIC TEMPERATURES"
- PATENT ABSTRACTS OF JAPAN vol. 9, no. 61 (E-303)(1784) 19 March 1985 ; & JP-A-59 198769
- Proceedings of MELECON '83 Mediterranean Electrotechnical Conference 24 May 1983, Athens, Greece pp. 1-2; G. GHIONE ET AL.: "COPLANAR LINES IN GaAs HYBRID STRUCTURES: INFLUENCE OF FLIP-CHIP INSERTION"
- 5TH IEEE/CHMT INTERNATIONAL ELECTRONIC MANUFACTURING TECHNOLOGY SYMPOSIUM 10 October 1988, LAKE BUENA VISTA, FL, USA pages 23 - 27; K.HATADA ET AL.: "A NEW LSI BONDING TECHNOLOGY "MICRON BUMP BONDING ASSEMBLY TECHNOLOGY""
- PATENT ABSTRACTS OF JAPAN vol. 11, no. 217 (E-523)(2664) 14 July 1987 ; & JP-A-62 35634

## Description

The present invention relates to a semiconductor-based radiation image detector and its manufacturing method, the detector detecting a radiation image such as that of X-rays with the image divided into pixels

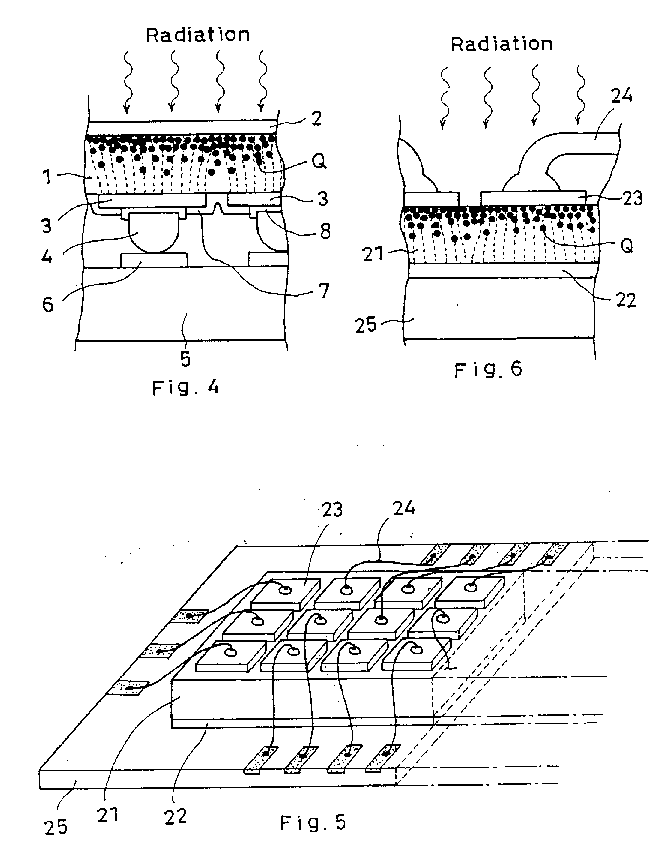

A conventional example of such radiation image detectors consists, as is shown in Figure 5, essentially of a slender radiation-detective semiconductor base 21 having its radiation image receiving front surface provided with one or a few arrays of pixel-corresponding signal takeout electrodes 23 and its back surface plated with a common bias electrode 22. In this manner, arrayed pixel-corresponding unit radiation sensors are formed, each between the common bias electrode 22 and each of the pixel-corresponding signal takeout electrodes 23. The semiconductor base 21 on which are thus formed many pixel-corresponding unit radiation sensors is mounted on a terminal board 25 with the signal takeout electrodes 23 wired by their respective lead wires 24 to terminals 26 printed on the marginal portions of the terminal board 25. The thus constituted one-dimensionally prolonged radiation image detector is made to scan an imaginary plane on which lies an invisible two-dimensional radiation image to be detected.

As is easily understood, such a one-dimensional detector can not instantly detect a two-dimensional image and takes a fairly long time for complete detection of one image because of the scanning operation of the detector. Further, a detector moving mechanism is inevitable. These disadvantages can easily be eliminated or reduced, in principle, by making the detector enlarged two-dimensionally so that it may entirely or partially cover the area of a radiation image to be detected, though in the case of a partially covering detector an image detection operation is necessarily repeated a few times with the detector displaced to complete the detection of one radiation image.

In practice, however, two-dimensional enlargement of the detector is accompanied, as a matter of course, by a tremendous increase in the number of signal takeout electrodes 23, and therefore, of lead wires 24 running crosswise over the signal takeout electrodes 23, often causing the lead wires 24 to be short-circuited. Further, the conventional detector of this type has a disadvantage that the radiation photons falling on the clearances left among the signal takeout electrodes 23 cannot be efficiently converted to electrical signals, because most of the electric carriers Q created by such photons are, as is schematically illustrated in Figure 6, substantially out of carrier acceleration fields developed between the common bias electrode 22 and the signal takeout electrodes 23, and so vanish without contributing to image signals.

An object of the present invention is to provide a large-surfaced two-dimensional radiation image detector by overcoming the above described difficulties involved in two-dimensionally enlarging the conventional radiation image detector consisting of many pixel-corresponding unit radiation sensors.

Another object of the present invention is to make such a two-dimensional radiation image detector capable of making use of all the electric carriers created by the incident photons including those falling on the portions corresponding to the clearances left among the signal takeout electrodes.

A further object of the present invention is to provide a method of manufacturing such a two-dimensional radiation image detector.

U.S. Patent Specification US-A-4 670 653 is concerned with an infra-red imaging system using an array of detections formed as diffusion wells in a Mercury-Cadmium-Telluride layer. Each detector is connected by a metallurgical conductor to one of an array of bumps of Indium. Those bumps are in contact with a similar array of bumps on an integrated cell substrate which are themselves formed on metallurgical interconnections on the substrate.

The radiation image detector in accordance with the present invention is defined in claim 1 and a method of manufacturing such a radiation image detector is defined in claim 4.

An example of the two-dimensional radiation image detector according to the present invention consists essentially of a radiation sensitive semiconductor plate having its one surface provided with a common bias electrode and its other surface provided with a plurality of pixel-corresponding signal takeout electrodes having thereon their respective bumps for leading out electric signals from the signal takeout electrodes. Further, the signal takeout electrodes, with the bumps excluded, and the clearances left among the signal takeout electrodes, are coated with a passivation film. With the radiation image detector having its main part thus constituted, the bumps provided on the signal takeout electrodes are, by means of a flip-chip joining technique, soldered to corresponding pads which are arranged on a separately prepared base plate. The pads are electrically led toward the edges of the base plate by their respective lead circuits printed on the same base plate. Electric image signals outputted from the signal takeout electrodes are thus led out to an external electronic circuit system through the pads and the accompanying printed lead circuits.

According to another example of the detector based on the present invention, the radiation image detector has its main part detachably connected to the base plate.

Any of the radiation image detectors according to the present invention is used with the common bias electrode side directed to incident radiation.

The method of manufacturing the above radiation image detectors, which method also belongs to the present invention, comprises a technique of photoprocessing.

According to the present invention the radiation image detector is advantageously free from a large number of lead wires running over the signal takeout electrodes. In addition, since a radiation image is received on the common bias electrode side, all of the electric carriers created within a shallow depth of the semiconductor plate are taken out as image signals (refer to Figure 4).

An embodiment of the present invention will now be described by way of example with reference to the accompanying drawings, in which:
Figure 1 shows an exploded one-point perspective view illustrating the correspondence of a radiation image detector main part to a base plate according to the present invention;
Figure 2 shows a partial side view illustrating the state of cooperation between the radiation image detector main part and the base plate, both shown in Figure 1;
Figure 3 illustrates stepwise a process of manufacturing the radiation image detector main part shown in Figures 1 and 2;
Figure 4 illustrates the electric carriers created in a radiation image detector according to the present invention;
Figure 5 shows a perspective view of a one-dimensionally prolonged conventional radiation image detector; and
Figure 6 illustrates the elecric carriers created in the conventional radiation image detector shown in Figure 5.

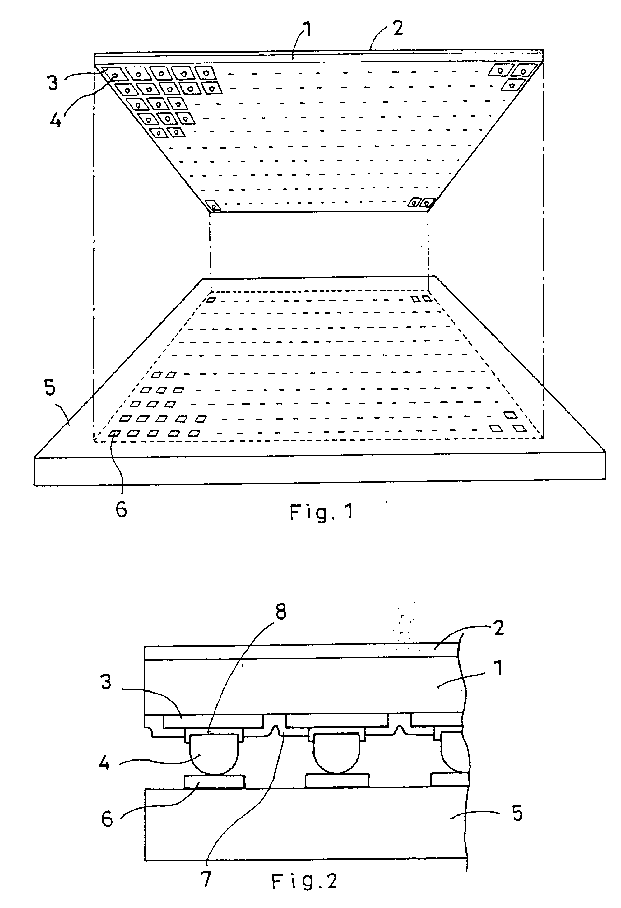

Referring to Figure 1, a radiation image detector as an embodiment of the present invention consists essentially of a radiation sensitive semiconductor plate 1 having its upper surface plated with a common bias electrode 2 and its lower surface plated with a plurality of pixel-corresponding signal takeout electrodes 3 having at their centres their respective bumps 4. Though the lower surface is further coated with a passivation film 7 with the bumps 4 excluded and the bumps 4 are fixed to the electrodes 3 with a gold layer 8 interposed, not all of these are shown in Figure 1. Their details are best shown in Figure 2 to be mentioned later. The radiation image detector is made up of many radiation sensors, each comprising the common bias electrode 2 and a respective pixel-corresponding signal takeout electrode 3, with the semiconductor plate 1 interposed therebetween. With the thus constituted radiation image detector made to cooperate with a separately prepared base plate 5 having on its surface a plurality of pads fixedly arranged corresponding to the signal takeout electrodes 3 of the radiation image detector, all the bumps 4 of the signal takeout electrodes 3 come into contact with the corresponding pads 6, as is shown in Figure 2 which illustrates the cooperating state between the radiation image detector main and the base plate 5. In the figure, reference numerals 7 and 8 respectively indicate the passivation film and the gold layers deposited on the surfaces of the signal takeout electrodes 3.

In the above embodiment the radiation image detector has the bumps 4 made to detachably come into contact with the pads 6, but the present invention can be embodied also with the base plate fixedly combined with the radiation image detector into one body by soldering the bumps 4 to the pads 6. In this case, the bumps 4 themselves are preferably made of solder.

In addition to the above constructional features of the radiation image detectors according to the present invention, any of them is expected to be applied with the common bias electrode side directed to the incident radiation which gives a radiation image to be detected.

According to the present invention, therefore, the radiation image detector not only is free from complicatedly intertwined lead wires which, wired over the signal takeout electrodes, may cause short-circuit troubles, but also has an advantage that all of the dense electric carriers Q generated in a shallow depth just below the common bias plate 2 are substantially fully converted to electric signals, because the electric fields developed between the common bias electrode 2 and the signal takeout electrodes 3, as is easily supposed from Figure 4, show a continuous distribution along the surface of the common bias electrode 2.

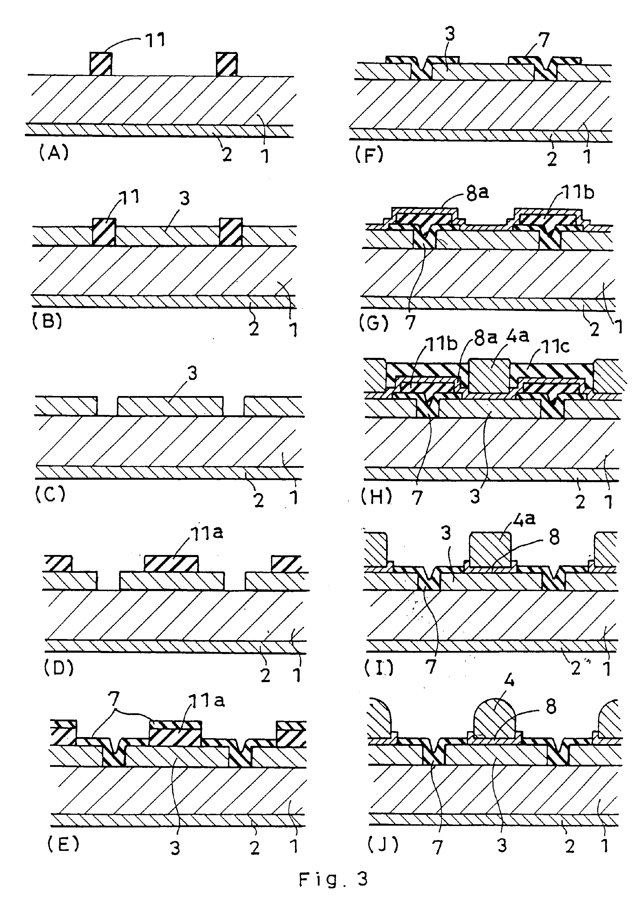

In the following, a method of manufacturing such radiation image detectors as mentioned above is described with reference to Figure 3. The method also belongs to the present invention. In Figure 3 is illustrated a series of steps A to J contained in a process of forming the radiation image detector main.

In the first place, a photoresist emulsion is applied to the upper surface of a GaAs, CdTe or the like compound semiconductor plate 1 having its lower surface plated with a common bias electrode 2 of gold, platinum, nickel or aluminium, and then the emulsion is photo-processed so as to leave a photoresist film 11 there except for portions where signal takeout electrodes are to be deposited (step A).

With the remaining photoresist film 11 used as a masking film, nickel is deposited on the semiconductor plate 1 by means of non-electrolytic plating to form signal takeout electrodes 3 (step B). The non-electrolytic nickel plating method can of course be replaced by a nickel evaporating method.

After the signal takeout electrodes, 3 are thus formed, the remaining photoresist film 11 is removed by dissolving it with a suitable solvent (step C).

Next, a photoresist emulsion is again applied covering the signal takeout electrodes 3 and the clearances left among them, and then photo-processed so as to leave photoresist films 11a on the signal takeout electrodes 3 and their respective central portions (step D), where signal lead-out bumps are to be finally fixed by means of electroplating.

With bump fixing portions thus preserved, a protective passivation film 7 of silicon oxide or silicon nitride is deposited thereon by evaporation or by an electron cyclotron resonance plasma CVD method, covering the semiconductor plate 1, signal takeout electrodes 3 and their respective photoresist films 11a (step E).

Then, the photoresist films 11a are dissolved with a solvent, and the photoresist films 11a removed to lift off parts of passivation film 7 deposited thereon. Thus the passivation film 7 is left only on the areas except for the central portions of the signal takeout electrodes 3 (step F). These central portions are just the above mentioned bump fixing portions.

With only the bump fixing portions thus made exposed on the signal takeout electrodes 3, a photoresist film 11b is laid only on the remaining passivation films 7 by means of a photo-processing method with their marginal portions excluded, and then as thin a continuous gold layer 8a as possible is deposited thereon by means of evaporation on all the surface of the photoresist film 11b and the so far exposed (central) portions of the signal takeout electrodes 3 (step G).

With the gold layer 8a thus laid, further a photoresist film 11c is formed thereon except for the bump fixing portions now made recessed due to the surrounding passivation film 7. Then soldering metal is accumulated on the recessed portions by means of electroplating with the gold layer 8a used as an electrode to form there pre-bump solder protrusions 4a (step H).

After the solder protrusions 4a are formed, the photoresist film 11c, the gold layer 8a and the photoresist film 11b are successively removed by means of dissolving the photo resist films and lifting off the gold layer (step I). Since the gold layer 8a is very thin as mentioned above, it can be lifted off relatively easily either by dissolving the photo resist films with a supersonic wave applied or by partially tearing the gold layer 8a mechanically with a photoresist dissolving solvent sprayed.

Finally, after the solder protrusions 4a have been thus exposed, temperature is raised to the melting point of the solder, and the solder protrusions melt to form solder beads as the signal lead-out bumps 4 (step J).

The gold layer 8a employed in the above process can be replaced with any other metal layer, if it is of a metal resistant to electrolytic solution used in the electroplating of solder. For the purpose silver, copper or aluminium also is usable. In addition, the metal layer may be formed as a multi-layer made by combining silver, copper or aluminium with nickel, chromium or aluminium.

The radiation image detector main part thus constituted is then combined with a separately prepared base plate 5 (as shown in Figure 2) on which are provided a two-dimensional array of pads 6 corresponding to the signal lead-out bumps 4. In combining both, the bumps 4 of the detector main are solder-joined to the corresponding pads 6 of the base plate 5 by means of a flip-chip joining technique.

As is mentioned previously, an embodiment of the present invention has the detector main part detachably combinable with the base plate, without solder-joining the bumps 4 to the pads 6. In this case, however, it is desirable to constitute the bumps 4 with any other suitable metal that is not as soft as a solder metal, but wear-resistant and somewhat elastic.

## Claims

1. A radiation image detector for detecting a radiation image with the image divided into pixels, comprising:
a radiation-sensitive semiconductor plate (1);
a common bias electrode (2) deposited on one surface of the semiconductor plate;
a plurality of pixel-corresponding signal takeout electrodes (3) deposited on the other surface of the semiconductor plate;
a plurality of bumps (4) each of which is fixed on a respective one of the signal takeout electrodes;
a passivation film (7) covering each signal takeout electrode where not in contact with its bump, and covering the clearances between the signal takeout electrodes; and
a base plate (5) on which are provided a plurality of contact pads (6) corresponding to and in contact with the bumps.

2. A radiation image detector according to claim 1, characterized in that the bumps (4) are made of a solder metal.

3. A radiation image detector according to claim 1 or 2, characterized in that the signal takeout electrodes (3) are of nickel.

4. A method of manufacturing a radiation image detector for detecting a radiation image with the image divided into pixels, the method comprising:
plating a semiconductor plate (1) on its one surface with a common bias electrode (2);
plating said semiconductor plate (1) on its other surface with a plurality of pixel-corresponding signal takeout electrodes (3);
depositing a passivation film (7) covering the signal takeout electrodes except for a portion of each, and covering clearances left among the signal takeout electrodes;
providing metal protrusions (4a,4) on the uncovered portions of the signal takeout electrodes, and
placing the protrusions (4) in contact with correspondingly-arranged contact pads (6) on a base plate (5).

5. A method according to claim 4 wherein the metal protrusions (4, 4a) are attached to their respective contact pads (6).

6. A method according to claim 5 in which the protrusions (4) are made of solder which serves for attachment of the protrusions to the contact pads (6).

7. A method as claimed in claim 6 in which the plating of said semiconductor plate (1) with signal takeout electrodes (3) includes laying, in advance, a first photoresist film (11) so as to define positions to be plated with the signal takeout electrodes, the first photoresist film being removed after the positions are plated with the signal takeout electrodes;
and the method includes the following further steps;
a first step of laying second photoresist films (11a) on respective central portions of the signal takeout electrodes by employing a photomasking technique;
a second step of depositing the passivation film (7) to cover the signal takeout electrodes, the second photoresist films and the clearances left among the signal takeout electrodes;
a third step of removing the second photoresist films together with parts of said passivation film deposited on the second photoresist films;
a fourth step of laying, by employing photomasking technique, a third photoresist film (11b) on parts of the passivation film remaining after the third step;
a fifth step of depositing a metal layer (8a) on all the surface formed by the fourth step, the metal layer having recessed portions corresponding to the respective central portions of the signal takeout electrodes;
a sixth step of laying, by employing a photomasking technique, a fourth photoresist film (11c) on the metal layer except for the recessed portions;
a seventh step of providing the solder metal protrusions (4a) at the recessed portions by means of electroplating with the metal layer used as an electrode;
an eighth step of removing the fourth and the third photoresist films (11c, 11b) together with parts of the metal layer deposited on the third photoresist film;
a ninth step of melting the solder protrusions so as to form solder beads (4); and
a tenth step of soldering, by means of a flip-chip joining technique, the solder beads to the contact pads on the base plate.

8. A method defined in claim 7, characterized in that the metal layer (8a) is of gold.

9. A method defined in claim 7, characterized in that the metal layer (8a) is a multi-layer consisting of gold and nickel.

10. A method defined in any of claims 5 to 9, characterized in that the signal takeout electrodes (3) are of nickel.

## Patentansprüche

1. Strahlungsbilddetektor zum Erfassen eines in Bildelemente unterteilten Strahlungsbildes, umfassend:
eine strahlungsempfindliche Halbleiterplatte (1);
eine gemeinsame Vorspannungselektrode (2), mit der eine Seite der Halbleiterplatte beschichtet ist;
eine Vielzahl von Bildelementen entsprechenden Signalentnahme- bzw. Signalabgabeelektroden (3), die auf der anderen Seite der Halbleiterplatte angebracht sind;
eine Vielzahl von Kontaktwarzen (4), deren jede auf einer zugehörigen Signalabgabeelektrode befestigt ist;
einen Passivierungsfilm (7), der jede Signalabgabeelektrode dort abdeckt, wo sie nicht in Kontakt mit ihrer Warze steht, und der die Zwischenräume zwischen den Signalabgabeelektroden abdeckt; und
eine Basisplatte (5), auf der eine Vielzahl von Anschlußflächen (6) korrespondierend zu den Kontaktwarzen und mit diesen in Kontakt stehend angeordnet sind.

2. Strahlungsbilddetektor nach Anspruch 1, dadurch gekennzeichnet, daß die Kontaktwarzen (4) aus Lötmetall bestehen.

3. Strahlungsbilddetektor nach Anspruch 1 oder 2, dadurch gekennzeichnet, daß die Signalabgabeelektroden (3) aus Nikkel bestehen.

4. Verfahren zum Herstellen eines Strahlungsbilddetektors zum Erfassen eines Strahlungsbildes, wobei das Bild in Bildelemente aufgeteilt ist, umfassend die Verfahrensschritte:
Beschichten einer Halbleiterplatte (1) auf ihrer einen Seite mit einer gemeinsamen Vorspannungselektrode (2);
Beschichten der genannten Halbleiterplatte (1) auf ihrer anderen Seite mit einer Vielzahl von Bildelementen entsprechenden Signalabgabeelektroden (3);
Aufbringen eines Passivierungsfilms (7), der die Signalabgabeelektroden mit Ausnahme eines Abschnitts jeder Elektrode sowie die Zwischenräume zwischen den Signalabgabeelektroden abdeckt;
Anbringen von Metallvorsprüngen (4a, 4) auf den unabgedeckten Abschnitten der Signalabgabeelektroden; und
In-Berührung-Bringen der Vorsprünge (4) mit entsprechend angeordneten Anschlußflächen (6) auf einer Basisplatte (5).

5. Verfahren nach Anspruch 4, wobei die Metallvorsprünge (4, 4a) an ihren entsprechenden Anschlußflächen (6) befestigt werden.

6. Verfahren nach Anspruch 5, bei dem die Vorsprünge (4) aus Lötmetall bestehen, das zum Befestigen der Vorsprünge an den Anschlußflächen (6) dient.

7. Verfahren nach Anspruch 6, bei dem das Beschichten der genannten Halbleiterplatte (1) mit Signalabgabeelektroden (3) das vorherige Aufbringen eines ersten Photoresistfilms (11) umfaßt, um die mit den Signalabgabeelektroden zu beschichtenden Stellen zu definieren, wobei der erste Photoresistfilm entfernt wird, nachdem die Positionen mit den Signalabgabeelektroden beschichtet worden sind;
und das Verfahren folgende weitere Schritte umfaßt:
einen ersten Schritt des Aufbringens eines zweiten Photoresistfilms (11a) auf den jeweiligen zentralen Bereich der Signalabgabeelektroden durch Anwendung einer Photomaskentechnik;
einen zweiten Schritt des Aufbringens des Passivierungsfilms (7) zum Abdecken der Signalabgabeelektroden, der zweiten Photoresistfilme und der Zwischenräume zwischen den Signalabgabeelektroden;
einen dritten Schritt des Entfernens der zweiten Photoresistfilme zusammen mit Teilen des genannten Passivierungsfilms, der auf die zweiten Photoresistfilme aufgebracht worden ist;
einen vierten Schritt des Aufbringens mittels der Photomaskentechnik eines dritten Photoresistfilms (11b) auf die nach dem dritten Schritt verbleibenden Teile des Passivierungsfilms;
einen fünften Schritt des Niederschlagens einer Metallschicht (8a) auf der gesamten durch den vierten Schritt gebildeten Fläche, wobei die Metallschicht vertiefte Teile aufweist, die dem jeweiligen zentralen Bereich der Signalabgabeelektroden entsprechen;
einen sechsten Schritt des Aufbringens mittels einer Photomaskentechnik eines vierten Photoresistfilms (11c) auf die Metallschicht mit Ausnahme der vertieften Teile; einen siebenten Schritt des Ausbildens der Lötmetallvorsprünge (4a) in den vertieften Abschnitten durch elektrisches Beschichten, wobei die Metallschicht als Elektrode dient;
einen achten Schritt des Entfernens des vierten und dritten Photoresistfilms (11c, 11b) zusammen mit Teilen der auf den dritten Photoresistfilm aufgebrachten Metallschicht;
einen neunten Schritt des Schmelzens der Lötmetallvorsprünge, um Lötmetallperlen (4) auszubilden; und
einen zehnten Schritt des Verlötens der Lötmetallperlen mit den Anschlußflächen auf der Basisplatte mittels eines Flip-Chip-Befestigungsverfahrens.

8. Verfahren nach Anspruch 7, dadurch gekennzeichnet, daß die Metallschicht (8a) aus Gold besteht.

9. Verfahren nach Anspruch 7, dadurch gekennzeichnet, daß die Metallschicht (8a) eine Mehrlagenschicht aus Gold und Nickel ist.

10. Verfahren nach jedem der Ansprüche 5 bis 9, dadurch gekennzeichnet, daß die Signalabgabeelektroden (3) aus Nickel bestehen.

## Revendications

1. Un détecteur d'image provenant de radiations pour la détection d'une image divisée en pixels, comprenant :
une plaque semi-conductrice sensible aux radiations (1) ;
une électrode commune de polarisation (2) déposée sur une surface de la plaque semi-conductrice ;
une pluralité d'électrodes de sortie de signaux (3) correspondant aux pixels, et déposées sur l'autre surface de la plaque semi-conductrice ;
une pluralité de surépaisseurs (4) dont chacune est fixée sur une électrode respective de sortie de signaux ;
une couche de passivation (7) couvrant chaque électrode de sortie de signaux là où elle n'est pas en contact avec sa surépaisseur et couvrant les espaces situés entre les électrodes de sortie de signaux ; et
une plaque de base (5) sur laquelle est prévue une pluralité de plots de contact (6) correspondant aux surépaisseurs et en contact avec celles-ci.

2. Un détecteur d'image radiative selon la revendication 1, caractérisé en ce que les surépaisseurs (4) sont réalisées en métal à braser.

3. Un détecteur d'image radiative selon la revendication 1 ou 2 caractérisé en ce que les électrodes de sortie de signaux (3) sont en nickel.

4. Un procédé de fabrication d'un détecteur d'image radiative pour la détection d'une image radiative dont l'image est divisée en pixels, le procédé comprenant :
le revêtement d'une plaque semi-conductrice (1) sur une de ses faces avec une électrode ordinaire de polarisation (2) ;
le revêtement de ladite plaque semi-conductrice (1) sur son autre face avec une pluralité d'électrodes de sortie de signaux correspondant aux pixels (3) ;
le dépôt d'une couche de passivation (7) couvrant les électrodes de sortie de signaux excepté une partie de chacune, et couvrant les espaces existant entre les électrodes de sortie de signaux ;
l'apport de saillies métalliques (4a, 4) sur les parties découvertes des électrodes de sortie de signaux et
la mise en contact des saillies (4) avec des plots de contact (6) disposés de manière correspondante sur une plaque de base (5).

5. Un procédé selon la revendication 4 dans lequel les saillies métalliques (4a, 4) sont fixées à leur plot de contact respectif (6).

6. Un procédé selon la revendication 5 dans lequel les saillies (4) sont réalisées en soudure tendre qui sert à fixer les saillies aux plots de contact (6).

7. Un procédé selon la revendication 6, dans lequel le revêtement de ladite plaque semi-conductrice (1) avec des électrodes de sortie de signaux (3) comprend le dépôt, préalable, d'une première couche de résine photosensible (11) afin de définir les emplacements à recouvrir avec les électrodes de sortie de signaux, la première couche de résine photosensible étant enlevée après que les emplacements ont été recouverts avec les électrodes de sortie de signaux ;
et le procédé comprend les autres étapes suivantes :
une première étape de dépôt d'une seconde couche de résine photosensible (11a) sur la partie centrale respective des électrodes de sortie de signaux en utilisant une technique de photomasquage ;
une seconde étape de dépôt de la couche de passivation (7) pour couvrir les électrodes de sortie de signaux, la seconde couche de résine photosensible et les espaces restant entre les électrodes de sortie de signaux ;
une troisième étape d'enlèvement de la seconde couche de résine photosensible avec des parties de ladite couche de passivation déposée sur cette seconde couche de résine photosensible ;
une quatrième étape consistant à déposer, en utilisant une technique de photomasquage, une troisième couche de résine photosensible (11b) sur des parties de la couche de passivation restant après la troisième étape ;
une cinquième étape de dépôt d'une couche métallique (8a) sur toute la surface formée par la quatrième étape, la couche métallique ayant des parties en creux correspondant aux parties centrales respectives des électrodes de sortie de signaux ;
une sixième étape consistant à déposer, en utilisant une technique de photomasquage, une quatrième couche de résine photosensible (11c) sur la couche métallique excepté sur les parties en creux,
une septième étape consistant à placer les saillies en métal à braser (4a) sur les parties en creux par électroplastie avec la couche métallique utilisée comme électrode ;
une huitième étape consistant à enlever les quatrième et troisième couches de résine photosensible (11c, 11b) avec des parties de la couche métallique déposée sur la troisième couche de résine photosensible ;
une neuvième étape consistant à fondre les saillies en métal à braser de manière à former des perlures de brasage (4) ; et
une dixième étape consistant à souder, par une technique d'assemblage de micro-pavés, les perlures de brasage aux plots de contact se trouvant sur la plaque de base.

8. Un procédé défini dans la revendication 7, caractérisé en ce que la couche métallique (8a) est en or.

9. Un procédé défini dans la revendication 7, caractérisé en ce que la couche métallique (8a) est à plusieurs couches et composée d'or et de nickel.

10. Un procédé défini dans l'une quelconque des revendications 5 à 9 caractérisé en ce que les électrodes de sortie de signaux sont en nickel.
